# EUROPEAN PATENT APPLICATION

(11) **EP 1 130 627 A1**
(43) Date of publication of application: **05.09.2001**
(21) Application number: 00944434.0
(22) Date of filing: 17.07.2000
(51) Int. Cl.: H01L 21/027, H05B 3/68

(54) **HOT PLATE UNIT**

(30) Priority: 09.08.1999 JP 22533599
(71) Applicant: IBIDEN CO., LTD., Ogaki-shi Gifu-ken 503-8604 (JP)
(72) Inventor: FURUKAWA, Masakazu, Ibi-ggun, Gifu 501-0695 (JP); ITO, Yasutaka, Ibiden Co., Ltd. Ogaki-kita Plant, Ibi-gun, Gifu 501-0695 (JP)
(74) Representative: Müller, Frank Peter, Dipl.-Ing.
(86) International application number: JP0004785
(87) International publication number: WO0111663

(57) **Abstract**

A hot plate unit capable of uniformly cooling a hot plate within a short period of time. The hot plate unit (1) includes a hot plate (3) including a heating element (10) and a casing (2) that supports the hot plate. The hot plate and the casing define an internal space S1. Two intake ports (17) and two lower opened portions (31) are formed in the bottom wall (2a) of the casing.

## Description

### TECHNICAL FIELD

The present invention relates to a hot plate unit employed, for example, during a semiconductor device manufacturing process.

### BACKGROUND ART

During a semiconductor manufacturing process, a photosensitive resin is applied to a silicon wafer. Then, a heating apparatus, such as a hot plate unit, dries the photosensitive resin.

For example, Japanese Examined Patent Publication No. 4-13873 describes a prior art heating apparatus. The heating apparatus includes a hot plate made of sintered aluminum nitride and a resistor arranged in the plate. The resistor is arranged between two sheets of a ceramic base material. The resistor has two terminals projecting from the side of the hot plate. The two terminals are connected to a power supply via a power line.

A silicon wafer is placed on an upper surface of the hot plate. When the resistor is energized, the silicon wafer is heated to a predetermined temperature (e.g., 100 to 900°C).

When the silicon wafer is removed from the hot plate after the photosensitive resin is dried, the hot plate is cooled to a relatively low temperature. However, a relatively long time is necessary to cool the hot plate. Thus, it is difficult to increase productivity.

Accordingly, for example, Japanese Examined Patent Application No. 8-8246 describes a technique in which a cooling body with heat radiating fins is attached to the hot plate to shorten the cooling time of the hot plate. However, the cooling body is capable of locally cooling the hot plate but not capable of uniformly cooling the entire hot plate.

### DISCLOSURE OF THE INVENTION

It is an object of the present invention to provide a hot plate unit that uniformly cools an entire hot plate within a short period of time with a simple structure and in an inexpensive manner.

To achieve the above object, a first perspective of the present invention is a hot plate unit including a casing having a bottom portion and a first opened portion and a hot plate arranged in the first opened portion and having a heating element. The bottom portion includes a second opened portion.

A second perspective of the present invention 6 is a hot plate unit including a hot plate having a heating element and a casing for supporting the hot plate. The casing includes a bottom portion facing the hot plate, a first opened portion covered by the hot plate, and a second opened portion formed in the bottom portion.

It is preferred that the hot plate unit further includes an intake port attached to the casing for enabling the intake of a fluid.

It is preferred that the intake port includes a plurality of intake ports.

It is preferred that the second opening includes a plurality of second openings.

It is preferred that the fluid includes air.

### BRIEF DESCRIPTION OF THE PREFERRED EMBODIMENTS

Fig. 1 is a schematic cross-sectional view showing a hot plate unit according to a first embodiment.

Fig. 2 is a partial enlarged cross-sectional view showing the hot plate unit of Fig. 1.

Fig. 3a and 3b are schematic bottom views showing a hot plate according to a further embodiment.

Fig. 4 is a graph illustrating the cooling speed of the hot plate unit of Fig. 1.

### BEST MODE FOR CARRYING OUT THE INVENTION

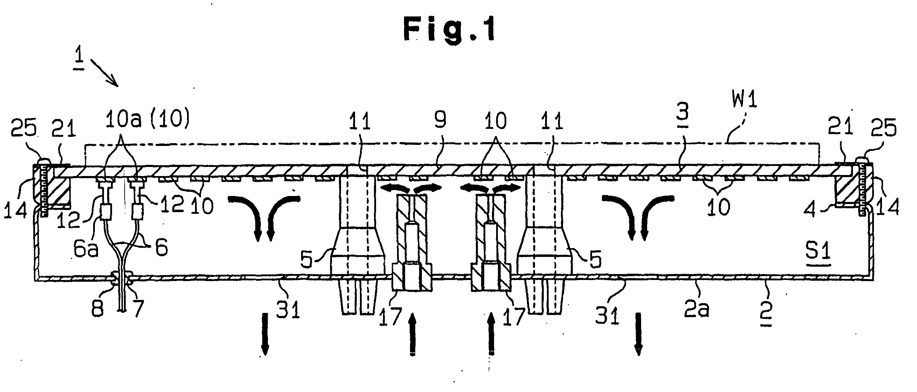

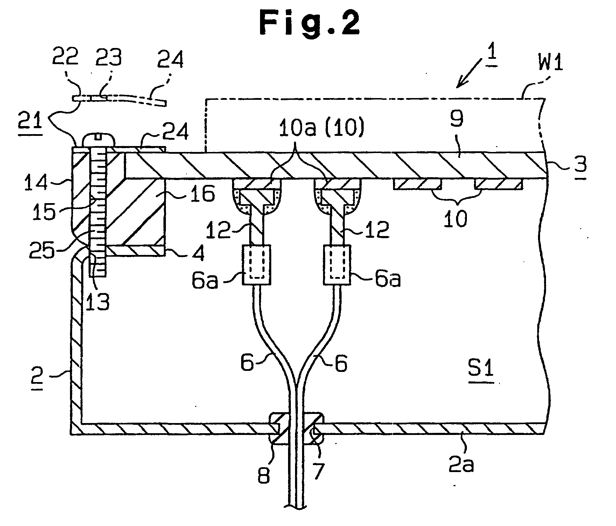

A hot plate unit 1 according to a first embodiment of the present invention will now be described with reference to Figs. 1 and 2.

With reference to Figs. 1 and 2, the main elements of the hot plate unit 1 are a metal (e.g., aluminum) casing 2 and a hot plate 3.

The casing 2 has a bottom wall 2a and an upper opened portion 4. Pin insertion sleeves 5, each of which receives a lift pin (not shown), are arranged near the center of the bottom wall 2a at three positions. The three lift pins support a silicon wafer W1 and lift the silicon wafer W1 to a predetermined height from the top surface of the hot plate 3. A lead wire hole 7 for receiving lead wires 6, which supply current to the hot plate 3, extends through a peripheral portion of the bottom wall 2a.

The hot plate 3 is a low-temperature hot plate that heats the silicon wafer W, to which a photosensitive resin is applied, to 200 to 300°C and dries the silicon wafer W. The hot plate 3 includes a plate-like base material 9, which is made of a sintered ceramic, and heating elements (resistors) 10, which are attached to the plate-like base material 9. The plate-like base material 9 is arranged on the upper opened portion 4 with a seal element 14 arranged in between. This defines an internal space S1 within the inner side of the casing 2 and the lower surface of the hot plate 3.

As shown in Fig. 1, the plate-like base material 9 is disk-like. The diameter of the plate-like base material 9 is slightly smaller than the external dimension of the casing 2. The heating elements 10 are concentric or spiral and attached to the lower surface of the plate-like substrate 9. Lift pin holes 11 are formed in the central portion of the hot plate 3 at positions corresponding to the three sleeves 5.

A sintered ceramic nitride, which has superior heat resistance and high heat conductivity characteristics, is selected as the material of the plate-like base material 9. It is preferred that the sintered ceramic nitride be a sintered metal nitride, such as aluminum nitride, silicon nitride, boron nitride, and titanium nitride. Sintered aluminum nitride, which has the highest heat conductivity among these sintered substances, is especially preferred. A sintered metal carbide ceramic, such as silicon carbide, zirconium carbide, titanium carbide, tantalum carbide, and tungsten carbide, may also be used.

The heating elements 10 are formed by fusing a conductive paste to the plate-like substrate 9. The conductive paste includes metal particles, a metal oxide, a resin, and a solvent. Preferred metal particles are, for example, gold, silver, platinum, palladium, lead, tungsten, and nickel. These metals are preferred because they withstand oxidation even under high temperatures and because their resistances are such that they are easily heated when energized. Preferred metal oxides are, for example, lead oxide, zinc oxide, silica, boron oxide, alumina, yttria, and titania.

Referring to Fig. 2, pads 10a, which serve as external connection terminals, are formed on two of the ends of the heating elements 10. A terminal pin 12 is soldered to each pad 10a. Two sockets 6a of the lead wires 6 are fitted to the distal end of the associated terminal pins 12. This electrically connects the terminal pins 12 to the heating elements 10. The heating elements 10 are heated when supplied with current via the lead wires 6 and the terminal pins 12 and thereby heat the entire hot plate 3.

With reference to Fig. 2, a plurality of equally spaced threaded attachment holes 13 extend through the top surface (lip portion) of the upper opened end portion 4. The seal element 14 is arranged on the lip. The inner diameter of the annular seal element 14 is substantially equal to the diameter of the upper opened portion 4. It is preferred that the seal element 14 be made of an elastic material, such as resin or rubber. The seal element 14 has a plurality of threaded holes 15 corresponding to the plurality of threaded holes 13. A stepped support 16 is formed on the inner wall of the seal element 14 to support the lower surface of the hot plate 3. When the hot plate 3 is arranged on the stepped support 16, the top surface of the seal element 14 is flush with the upper surface of the hot plate 3. The stepped support 16 supports the hot plate 3 so that it is generally horizontal.

The seal element 14 seals the space between the top surface of the upper opened portion 4 and the lower surface of the hot plate 3. This prevents fluid (air) from leaking through the space.

Referring to Figs. 1 and 2, an annular holder 21 is fixed to the seal element 14 by bolts 25. The annular holder 21 includes a ring 22, a plurality of threaded holes 23, and a plurality of holding tabs 24. The holding tabs 24 press the hot plate 3 toward the stepped support 15. The hot plate 3 is fixed between the seal element 14 and the annular holder 21.

Referring to Fig. 1, two intake ports 17 are fixed to the bottom wall 2a by fasteners, such as bolts. The intake ports 17 are arranged near the center of the bottom wall 2a. Two lower opened portions 31 extend through the bottom wall 2a. The lower opened portions 31 are located outward in the radial direction from the two intake ports 17. The interior and exterior of the casing 2 are communicated through the intake ports 17.

A female thread is formed in the lower inner surface of each intake port 17 to receive a fluid supply pipe (not shown). The other end of the fluid supply pipe opens at a somewhat distant location from the hot plate unit 1. A gas pump is arranged in the fluid supply pump to supply the interior of the casing 2 with cooling air via the intake ports 17.

Referring to Fig. 2, a seal packing 8 is fit into the lead wire hole 7. The seal packing 8 is an elastic body made of rubber or the like and has a through hole. The lead wires 6 are inserted through the through hole of the seal packing 8 and extended out of the casing 2. The seal packing 8 seals the space between the lead wires 6 and the lead wire hole 7. This prevents air from flowing through the lead wires 6 and the lead line hole 7.

The procedure for using the hot plate unit 1 will now be discussed.

A silicon wafer W1, to which a photosensitive resin has been applied, is placed on the hot plate 3. When the heating elements 10 are energized, the hot plate 3 is heated. The contact between the silicon wafer W1 and the hot plate 3 heats the silicon wafer W1. The heating continues until the photosensitive resin is sufficiently dried. After the drying, the heating elements 10 are de-energized.

Then, the gas pump is driven to supply the internal space S1 with cooling air through the intake ports 17. The cooling air is blown vertically against the lower surface of the hot plate 3 from the intake ports 17. In the internal space S1, the cooling air contacts the entire lower surface of the hot plate 3 and flows toward the lower opened portions 31. The flow cools the hot plate in a substantially uniform manner, and the cooling air absorbs the heat of the hot plate 3 and becomes hot. The hot air flows through the lower opened portions 31 and is discharged from the hot plate unit 1. The thick arrows in Fig. 1 schematically show the flow of the cooling air. When the hot plate 3 is cooled to a predetermined temperature, the silicon wafer W1 is removed from the hot plate 3.

A cooling efficiency experiment will now be discussed. The cooling efficiency of the hot plate unit 1 of the first embodiment was confirmed as described below. Changes in the surface temperature of the hot plate unit 3 that was heated to 200°C were measured. The time required for the surface temperature to be cooled to 25°C from 200°C (cooling time) was used as a cooling efficiency index. For comparison, the cooling efficiency of two prior art hot plate units was also measured in the same manner. The first prior art hot plate unit did not have a cooling means. The second prior art hot plate unit had a cooling means

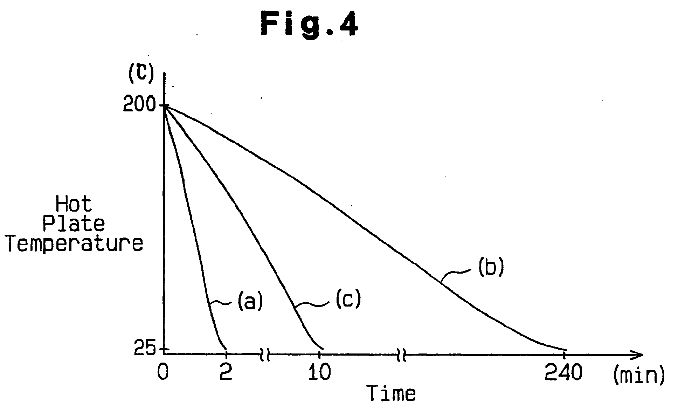

The results are shown in Fig. 4. Curve (a) represents the temperature change of the first embodiment. Curve (b) represents the temperature change of the first prior art example. Curve (c) represents the temperature change of the second prior art example. The cooling time was about two minutes in the hot plate unit 1 of the first embodiment. In comparison, the cooling time of the first prior art example was about 240 minutes. The cooling time of the second prior art example was about ten minutes. It was thus confirmed that the cooling time of the hot plate unit 1 of the first embodiment was shorter than that of the prior art and that the cooling efficiency was significantly improved.

The first embodiment has the advantages described below.
(1) The heat of the hot plate 3 is lowered efficiently by the fluid in the casing 2 that flows out of the casing 2 through the two lower opened portions 31 of the bottom wall 2a. As a result, the entire hot plate 3 is uniformly cooled within a short period of time.
(2) The lower opened portions 31 are formed merely by adding a process to drill the casing 2 during the manufacturing process of the hot plate unit 1. Thus, for example, in comparison to when adding a fluid discharge port to the casing 2, the manufacturing of the hot plate unit 1 is simplified and the manufacturing cost is reduced.
(3) The hot plate unit 1 has a simple structure in comparison to one that has a fluid discharge port. Thus, the hot plate unit 1 seldom fails to function and maintenance is facilitated.
(4) Cooling air is circulated in the internal space S1 of the casing 2 from the two intake ports 17 in the bottom wall 2a. The cooling air forcibly cools the entire hot plate 3. Further, the air that absorbs the heat of the hot plate 3 is discharged externally from the lower opened portions 31. This improves the circulating efficiency of the cooling air and uniformly cools the entire hot plate 3.
(5) The cooling air is blown vertically against the lower surface of the hot plate 3 from the intake ports 17. Thus, the hot plate 3 is efficiently cooled.
(6) The cooling air is drawn through the two intake ports 17. Thus, the cooling air uniformly contacts the entire lower surface of the hot plate 3.
(7) Projecting objects projecting from the lower surface of the hot plate 3, such as the terminal pins 12, are covered by the casing 2. Accordingly, the casing 2 may be attached to a support stage (not shown) without any difficulties regardless of whether or not there are projecting objects.
(8) The lower opened portions 31 are formed in the bottom wall 2a. This decreases the heat capacity of the casing 2 and enables easy discharge of the fluid. In other words, the cooling speed of the hot plate is increased by adding a simple process, which does not increase the manufacturing cost, to the manufacturing process of the hot plate unit 1.

The first embodiment may be modified as described below.

If a certain degree of sealing is guaranteed, the seal element 14 may be deleted. In this case, the hot plate 3 is arranged on the top surface of the upper opening portion 4 of the casing 2, and the annular holder 21 is fastened directly to the casing 2 by screws.

The number of the intake ports 17 may be increased to three or more. A larger number of the ports 17 uniformly cool the hot plate 3 within a shorter period of time. The number of the lower opened portions 31 may be increased to three or more.

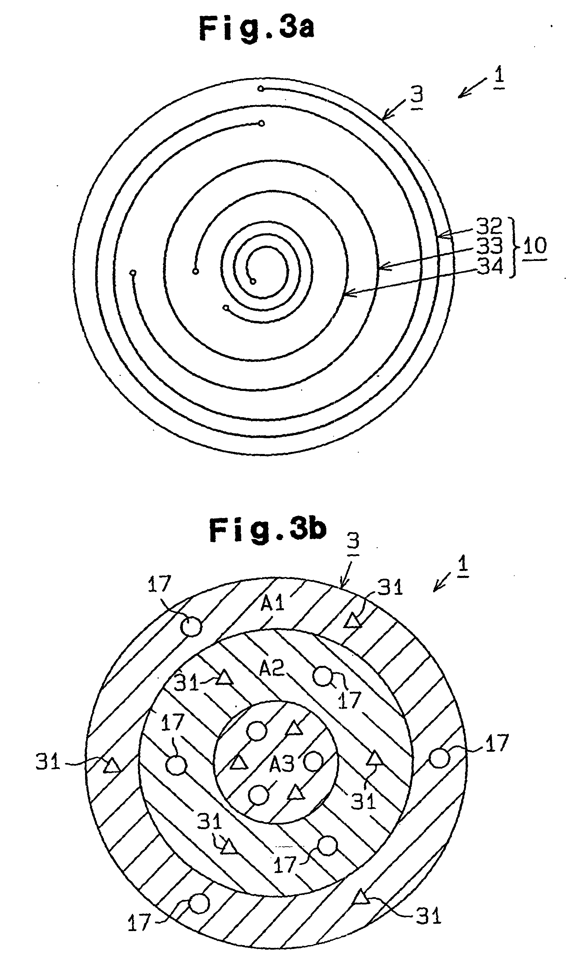

As shown in Fig. 3a, three separate resistors 32-34 may be employed as the heating elements 10. Three heat control circuits are used to heat the resistors 32-34 and independently control the power supplied to the resistors 32-34. In this case, three heating sections A1 to A3 are defined in the hot plate 3 as shown in Fig. 3b. A plurality of (e.g., three) intake ports 17 (marked by o) and lower opened portions 31 (marked by □) are arranged in each of the heating sections A1 to A3. In Fig. 3b, the three intake ports 17 and the three lower opened portions 31 arranged in the same heating section A1 to A3 are spaced in an equiangular manner. In other words, the three intake ports 17 and the three lower opened portions 31 in the same section are each located at an apex of a hypothetical equilateral triangle.

Accordingly, the activation and deactivation of the each control circuit controls the temperature of the associated heating section A1 to A3. Further, the cooling air drawn through the plural intake ports 17 cools each of the heating sections A1 to A3. Thus, the hot plate 3 is uniformly cooled.

The locations of the intake ports 17 and the lower opened portions 31 may be altered.

Further, the number of the intake ports 17 and the lower opened portions 31 in the same section may be at least one.

The number of heat. control circuits may be either two or four or more. In this case, the total number of the intake ports 17 need only be 70 percent or more of the number of heat control circuits, and one or more intake ports 17 need not be provided for each heat control circuit. For example, the number of intake ports 17 may be seven or more when there are ten heat control circuits and three or more when there are four heat control circuits.

The lead wire hole 7 may be formed in locations other than the bottom wall 2a of the casing 2, such as in the side wall of the casing 2.

A gas other then air, for example, an inert gas such as carbonic acid gas or nitrogen may be circulated as the cooling fluid in the internal space S1. Further, a fluid that does not affect electric circuits in an undesirable manner, such as an insulative liquid, may also be circulated.

A thermocouple may be embedded in the plate-like base material 9 to measure the temperature of the hot plate 3. Based on a detection signal of the thermocouple, the voltage and current provided to the heating element 10 is changed to control the temperature of the hot plate 3. In this case, a lead wire of the thermocouple is extended out of the casing through the seal packing 8.

## Claims

1. A hot plate unit comprising:
a casing having a bottom portion and a first opened portion; and
a hot plate arranged in the first opened portion and including a heating element, wherein the bottom portion includes a second opened portion.

2. The hot plate unit according to claim 1, further comprising an intake port attached to the casing for enabling the intake of a fluid.

3. The hot plate unit according to claim 2, wherein the intake port includes a plurality of intake ports.

4. The hot plate unit according to any one of claims 1 to 3, wherein the second opening includes a plurality of second openings.

5. The hot plate unit according to any one of claims 2 or 3, wherein the fluid includes air.

6. A hot plate unit comprising:
a hot plate including a heating element; and
a casing for supporting the hot plate, wherein the casing includes a bottom portion facing the hot plate, a first opened portion covered by the hot plate, and a second opened portion formed in the bottom portion.
